# EUROPÄISCHE PATENTSCHRIFT

(11) **EP 3 185 075 B1**
(45) Veröffentlichungstag und Bekanntmachung des Hinweises auf die Patenterteilung: **03.03.2021**
(21) Anmeldenummer: 15201844.6
(22) Anmeldetag: 22.12.2015
(51) Int. Cl.: G03F 7/20, B25B 11/00, H05K 3/02, H05K 13/00

(54) **VORRICHTUNG FÜR BELICHTUNGSSYSTEM**
DEVICE FOR EXPOSURE SYSTEM
DISPOSITIF DE SYSTEME D'EXPOSITION A LA LUMIERE

(43) Veröffentlichungstag der Anmeldung: 28.06.2017
(73) Patentinhaber: Heraeus Deutschland GmbH & Co. KG, 63450 Hanau (DE)
(72) Erfinder: Rogg, Alexander, 92724 Trabitz (DE); Wacker, Richard, 96135 Unteraurach (DE)
(74) Vertreter: Gille Hrabal

(56) Entgegenhaltungen:
- WO-A1-2015/114987
- CN-A- 105 101 644
- CN-U- 202 221 514
- US-A1- 2003 074 788
- US-A1- 2003 075 532
- US-A1- 2008 239 326
- US-A1- 2015 208 499
- LOGAN P: "KERAMIKTRAGER FUR HOCHSTE ANSPRUCHE", TECHNISCHE RUNDSCHAU, HALLWAG, BERN; CH, DE, vol. 81, no. 51/52, 22 December 1989 (1989-12-22), page 24/25, XP000095386, ISSN: 1023-0823

## Beschreibung

Die vorliegende Erfindung betrifft eine Vorrichtung zum Niederspannen von Metall-Keramik-Substraten, die in Belichtungssystemen zur Strukturierung von Metall-Keramik-Substraten Anwendung findet. Weiterer Gegenstand der vorliegenden Erfindung ist ein Verfahren zur Strukturierung von Metall-Keramik-Substraten unter Verwendung der erfindungsgemäßen Vorrichtung.

Üblicherweise werden zur Herstellung von strukturierten Metall-Keramik-Substraten photolithographische Prozesse angewendet. Hierbei wird auf einer photolithographische Schicht, die auf einem Substrat aufgebracht wurde, mittels Belichtungsanlagen ein Layout erzeugt (Strukturierung). Im Stand der Technik wird diese Strukturierung mit herkömmlichen Belichtungssystemen, die mittels Silber- oder Silberfilmkopien (Masken) fungieren, realisiert. Um einen optimalen Übertragung des Layouts auf das Belichtungsgut, also eine optimale Strukturierung des Belichtungsgut, zu gewährleisten, wird das Substrat üblicherweise mittels Vakuum in einem Spannsystem, beispielsweise in einer Glaskassette, niedergespannt, um zu gewährleisten, dass die Maske auf dem Belichtungsgut optimal aufliegt. Durch eine derartige Anordnung ohne Spalt zwischen Maske und Belichtungsgut soll sichergestellt werden, dass Fehler, wie Unterstrahlungen, vermieden werden.

Weiterhin darf auf den Stand der Technik gemäß WO 2015/114987 A, US 2008/239326 A, US 2003/074788 A und US 2003/075532 A verwiesen werden.

Metall-Keramik-Substrate weisen durch den Herstellungsprozess bedingt unterschiedliche Durchbiegungs- und Verwindungszustände auf. Das Niederspannen von Metall-Keramik-Substraten zum Zweck der Strukturierung übt daher in der Regel eine mechanische Belastung auf das Grundmaterial aus. So kann es bei dem Niederspannen beispielsweise zu einer punktuellen Belastung einer Keramikecke kommen, wodurch sich Partikel, beispielsweise Keramikpartikel, von dem Belichtungsgut ablösen. Dieser Partikel verbleiben in der Regel in dem verwendeten Spannsystem und können bei den nachfolgenden Belichtungszyklen z.B. in der Belichtungsmaske mechanisch verankert zu seriellen Fehlbelichtungen führen. Sollte es sich um größere Partikel handeln, kann es sogar zu einer irreparablen Schädigung, beispielsweise zu Mikrorissen in der Keramik oder zu mechanische Abdrücke im Metall, kommen.

Ein weiterer Nachteil der bekannten Systeme zum Niederspannen von Metall-Keramik-Substraten, die zur Bildung von Partikeln führen, ist, dass die abgespalteten Partikel lichtundurchlässig sind, so dass Fehlbelichtungen in den nachfolgenden Belichtungszyklen auftreten.

Die Aufgabe der vorliegenden Erfindung ist daher, eine Vorrichtung zum Niederspannen von Metall-Keramik-Substraten bereitzustellen, mit welchen die vorgenannten Nachteile im Wesentlichen vermieden werden. Insbesondere stellt sich die vorliegende Erfindung die Aufgabe, eine Vorrichtung zum Niederspannen von Metall-Keramik-Substraten bereitzustellen, mit welchem die mechanische Belastung des Metall-Keramik-Substrats reduziert wird und mit welcher Partikel, die sich von dem Metall-Keramik-Substrat durch das Niederspannen lösen, aus dem Spannsystem entfernt werden können ohne dass es zu Fehlbelichtungen, Mikrorissen in der Keramik oder mechanische Abdrücke im Metall kommt.

Gelöst werden diese Aufgaben durch eine Vorrichtung zum Niederspannen von Metall-Keramik-Substraten, umfassend einen Träger sowie ein auf dem Träger vorgesehenes Pad.

Die erfindungsgemäße Vorrichtung ist dann dadurch gekennzeichnet, dass das als Belichtungsnest verwendete Pad gegenüber dem Träger erhöht ist.

Durch den Einsatz von erhöhten Belichtungsnestern, die insbesondere aus einem weichen Grundmaterial bestehen, können durch das Niederspannen aus dem Metall-Keramik-Substrat abgelöste Partikel nicht wieder in den auf das Belichtungsgut bzw. auf die Spannvorrichtung gelangen. Der Partikel verbleibt somit in einem unkritischen Bereich außerhalb des Spannsystems und kann später einfach entfernt werden. Belichtungsfehler in den nachfolgenden Belichtungsschritten werden somit wirkungsvoll minimiert. Sollte es wider Erwarten dennoch zu einem Ablösen von Partikeln aus dem Metall-Keramik-Substrat kommen, kann eine mechanische Beschädigung des Metall-Keramik-Substrats sowie der nachfolgend zu strukturierenden Metall-Keramik-Substrate ausgeschlossen werden, da sich der Partikel beim Spannvorgang in das weiche Nest drücken kann und zwangsläufig nicht in die Substratoberfläche gedrückt wird.

Wie bereits ausgeführt, ist das als Belichtungsnest ausgebildete Pad vorzugsweise aus einem weichen Grundmaterial aufgebaut. In Frage kommen hierzu beispielsweise Kunststoffe, insbesondere elastisch verformbare Kunststoff, wie eine elastische Gummimasse.

Damit die möglicherweise abgespalteten Partikel aus dem Metall-Keramik-Substrat beim Niederspannen von dem Grundmaterial des Pads aufgenommen werden können, wird als Grundmaterial vorzugsweise eine vulkanisierte Gummimasse mit einer Härte von 20 bis 50 IRHD, weiter bevorzugt von 25 bis 45 IRHD, noch weiter bevorzugt 30 bis 40 IRHD, verwendet, wobei die Härte (IRHD) gemäß dem Standard ISO 48 - 1994 bestimmt wird.

Ein beispielsweise geeignetes Material zur Herstellung des Pads ist das kommerziell erhältliche Produkt Linatex®, das aus Naturkautschuk besteht und neben der erforderlichen weichen Grundstruktur noch weitere technische Eigenschaften aufweist, die für die Verwendung als Belichtungsnest von Vorteil sind.

Das als Belichtungsnest ausgebildete Pad weist Öffnungen auf, durch welche auf unterschiedliche Art ein Vakuum angelegt werden kann. Die genaue Beschreibung der Erzeugung eines Vakuums an den Öffnungen des Pads erfolgt weiter unten.

Das zu strukturierende Metall-Keramik-Substrat wird auf das Pad positioniert und durch das Vakuum, das durch die Öffnungen des Pads auf das Metall-Keramik-Substrat einwirkt, kommt es zu einem Niederspannen des Metall-Keramik-Substrats und damit zu der Ausbildung einer ausreichenden Ebenheit. Hierdurch werden Durchbiegungs- und Verwindungszustände des Metall-Keramik-Substrats im Wesentlichen egalisiert und eine möglichst optimale planare Metallbeschichtung auf dem Keramiksubstrat erzeugt, die dann einer Strukturierung unterworfen werden kann.

Damit ist das Pad der erfindungsgemäßen Vorrichtung einer gewissen mechanischen Beanstandung unterworfen, so dass das in dem Pad verwendete Grundmaterial bestimmte, weitere Materialeigenschaften aufweisen sollte.

In einer ersten Ausführungsform umfasst das Material des Pads daher eine vulkanisierte Gummimasse mit einem Modulus @ 500 von 1,0 bis 3,0 MPa, weiter bevorzugt von 1,2 bis 2,8 MPa, noch weiter bevorzugt 1,4 bis 2,6 MPa, handelt, wobei der Modulus @ 500 gemäß dem Standard ISO 37 - 2005 bestimmt wird.

In einer zweiten Ausführungsform umfasst das Material des Pads eine vulkanisierte Gummimasse mit einer Zugfestigkeit von 10 bis 50 MPa, weiter bevorzugt von 15 bis 45 MPa, noch weiter bevorzugt von 20 bis 40 MPa handelt, wobei die Zugfestigkeit gemäß dem Standard ISO 37 - 2005 bestimmt wird.

In einer dritten Ausführungsform umfasst das Material des Pads eine vulkanisierte Gummimasse mit einer Reißdehnung von 600 bis 1000 %, weiter bevorzugt 650 bis 950 %, noch weiter bevorzugt 700 bis 900 %, handelt, wobei die Reißdehnung gemäß dem Standard ISO 37 - 2005 bestimmt wird.

In weiteren bevorzugten Ausführungsformen der vorliegenden Erfindung weist das Grundmaterial zur Herstellung des Pads zwei oder alle drei der vorgenannten Eigenschaften (Modulus, Zugfestigkeit und/oder Reißdehnung) auf.

Das erfindungsgemäß zu verwendende Pad weist Öffnungen auf, die mit einer Vorrichtung zur Erzeugung eines Vakuums, beispielsweise einer Vakuumpumpe, verbunden sind.

Die Erzeugung des Vakuums auf der Oberseite des Pads und das damit bewirkte Niederspannen des Metall-Keramik-Substrats können auf unterschiedliche Art realisiert werden.

In einer ersten Ausführungsform weist der Träger selbst ebenfalls Öffnungen auf, wobei die Öffnungen des Trägers und die Öffnungen des Pads so zueinander angeordnet sind, dass sie miteinander kommunizieren können. Durch das Anlegen eines Vakuums an die Öffnungen im Träger wird das Vakuum durch den Träger und das Pad hindurch auf die Seite des Pads übertragen, auf welchem das Metall-Keramik-Substrat durch das Vakuum niedergespannt wird.

In einer zweiten Ausführungsform der vorliegenden Erfindung weist das Pad Öffnungen auf, in welche Balgsauger eingefasst sind. Entsprechende Balgsauger sind kommerziell erhältlich. Zum Niederspannen des Metall-Keramik-Substrats wird ein Vakuum an die Balgsauger angelegt. Dieses Vakuum kann wiederum mittels Vakuumpumpen erzeugt werden, welche mit Öffnungen in dem Träger verbunden sind, wobei die Öffnungen in dem Träger mit dem Innenvolumen der Balgsauger in Kontakt stehen. Im Vergleich zu der ersten Ausführungsform weist die Ausgestaltung unter Verwendung von Balgsaugern den Vorteil auf, dass die Leistung der zu verwendenden Vakuumpumpen kleiner sein kann, da nur das Innenvolumen der Balgsauger evakuiert wird und der Saugnapf der Balgsauger vor dem Anlegen des Vakuums bereits mit dem Metall-Keramik-Substrat in Kontakt gebracht werden kann. Im grundlegenden Unterschied zu der ersten Ausführungsform erfolgt daher in der zweiten Ausführungsform kein unnötiges Anziehen von Umgebungsluft, was die Verwendung einer geringer dimensionierten Vorrichtung zur Erzeugung des Vakuums (d.h. beispielsweis einer geringer dimensionierten Vakuumpumpe) ermöglicht. Darüber hinaus kann das Niederspannen wirkungsvoller als in der ersten Ausführungsform realisiert werden.

In einer dritten Ausführungsform der vorliegenden Erfindung kann das Vakuum ebenfalls über Löcher in dem Pad auf das Metall-Keramik-Substrat übertragen werden, wobei das Pad über Erhebungen verfügt, auf welchen das Metall-Keramik-Substrat aufliegt und welche einerseits mit dem Metall-Keramik-Substrat abgeschlossene kleine Vakuumräume bilden und andererseits den zwischen Pad und Metall-Keramik-Substrat vorhandenen Volumenraum unterteilen. Auch durch diese Ausführungsform ergibt sich der Vorteil, dass nur kleine Vakuumräume evakuiert werden müssen.

Die Öffnungen in dem Träger und dem Pad können beispielsweise kreisförmig ausgebildet sein.

In dem Fall der ersten und dritten Ausführungsform weisen die Öffnungen in dem Pad und dem Träger einen Durchmesser von vorzugsweise 1 bis 20 mm, weiter bevorzugt 3 bis 12 mm, noch weiter bevorzugt 5 bis 10 mm, auf.

In dem Fall der zweiten Ausführungsform weisen die Öffnungen in dem Pad einen Durchmesser von vorzugsweise 1 bis 5 cm, weiter bevorzugt 1,5 bis 4,5 cm, noch weiter bevorzugt 2 bis 4 cm, auf, so dass handelsübliche Balgsauer in das Pad eingelassen werden können.

Das Pad selbst kann entweder auf dem Träger aufliegen oder der Träger kann eine Ausnehmung aufweist, in welche das Pad eingelegt ist. In beiden Ausführungsformen ist das Pad jedoch gegenüber dem Träger erhöht.

Im Rahmen der vorliegenden Erfindung kann der Träger mehrere Pads, entweder flächig auf dem Träger oder aber eingelassen in die Ausnehmung aufweisen. In der letzteren Ausgestaltung ist es bevorzugt, wenn das Pad formschlüssig in der Ausnehmung aufgenommen wird,

In dem Fall der Ausführungsform mit einer Ausnehmung in dem Träger, in welchem das Pad eingelegt ist, kann das Pad eine Dichtlippe aufweisen, welche sich über die Fläche der Ausnehmung erstreckt und welche formschlüssig mit dem Träger abschließt. Dabei können das Pad und die Dichtlippe einstückig oder zweistückig ausgebildet sein.

Falls auf dem Träger eine Ausnehmung vorgesehen ist, so kann die Ausnehmung in dem Träger eine rechteckige Form, insbesondere eine quadratische Form, aufweisen.

Das Pad, entweder eingelassenen in die Ausnehmung oder planar auf dem Träger angeordnet, kann ebenfalls eine rechteckige Form, insbesondere eine quadratische Form, aufweisen.

In einer weiteren Ausgestaltung der vorliegenden Erfindung umfasst die erfindungsgemäße Vorrichtung zusätzlich ein auf dem Pad angeordnetes niedergespanntes Metall-Keramik-Substrat, welches durch Anlegen eines Vakuums über das Pad mit dem Träger verbunden ist. Dabei ist es insbesondere bevorzugt, wenn das niedergespannte Metall-Keramik-Substrat eine größere Grundfläche aufweist als die Grundfläche des Pads. Durch die Verwendung eines Metall-Keramik-Substrats und eines daran angepassten Pads derart, dass die Grundfläche des Metall-Keramik-Substrats größer ist als die Grundfläche des Pads, kann eine punktuelle Belastung der Ecken- und/oder Kantenbereiche des Metall-Keramik-Substrats im Wesentlichen vermieden werden. Damit werden die Randbereiche des Metall-Keramik-Substrats nicht direkt durch das Niederspannen beeinflusst.

Darüber hinaus ist in der erfindungsgemäßen Vorrichtung vorzugsweise vorgesehen, dass das Pad gegenüber dem Träger derart erhöht ist, dass ein auf dem Pad niedergespanntes Metall-Keramik-Substrat, dessen Grundfläche sich über die Grundfläche des Pads erstreckt, von dem Träger beabstandet ist. Bei einer derartigen Anordnung des Pads sowie des Metall-Keramik-Substrats beträgt der einzuhaltende Abstand zwischen Metall-Keramik-Substrat und Träger vorzugsweise mindestens 0,1 mm, weiter bevorzugt mindestens 0,3 mm, noch weiter bevorzugt mindestens 0,5 mm.

Darüber hinaus ist es bevorzugt, wenn der Träger um das Pad herum eine Ausfräsung zur Aufnahme von Partikeln aufweist, die sich durch das Niederspannen des Metall-Keramik-Substrats bilden können. Hierdurch wird der Einfluss von Partikeln, die sich von dem Metall-Keramik-Substrat ablösen, weiter reduziert, da sich diese Partikel in der Ausfräsung sammeln können.

Ferner ist es bevorzugt, wenn der Träger um das Pad eine Gitterstruktur zur Aufnahme von Partikeln aufweist, die sich durch das Niederspannen des Metall-Keramik-Substrats bilden können. Auch hierdurch wird der Einfluss von Partikeln, die sich von dem Metall-Keramik-Substrat ablösen, weiter reduziert, da diese Partikel durch das Gitter in einen Auffangbereich hindurch fallen können.

Eine weitere Ausgestaltung zur Vermeidung dieser störenden Partikeln ist die Verwendung einer Saugvorrichtung, die so ausgebildet ist, dass sie Partikel absaugen kann, die sich durch das Niederspannen des Metall-Keramik-Substrats bilden können.

Eine weitere Möglichkeit, den Einfluss von störenden Partikeln zu vermeiden, ist die Verwendung von Adhesivrollen zur Reinigung des Pads nach dem Niederspannen des Metall-Keramik-Substrats. In einer weiteren Ausführungsform der vorliegenden Erfindung umfasst die Vorrichtung daher auch noch Adhesivrollen zum Reinigen des Pads.

Die erfindungsgemäße Vorrichtung ist jedoch nicht beschränkt auf eine Verwendung in Kombination mit Metall-Keramik-Substraten, die eine größere Grundfläche aufweisen. Daher kann das niedergespannte Metall-Keramik-Substrat auch eine gleichgroße Grundfläche als das Pad aufweisen oder das niedergespannte Metall-Keramik-Substrat kann eine kleinere Grundfläche als das Pad aufweisen.

Im Rahmen der vorliegenden Erfindung können der Träger und das Pad der erfindungsgemäßen Vorrichtung im Wesentlichen horizontal angeordnet sein. In diesem Fall wird das Metall-Keramik-Substrat im Wesentlichen horizontal auf dem Pad niedergespannt. In einer weiteren Ausgestaltung kann das Pad auf dem Träger im Wesentlichen senkrecht angeordnet sein und das Metall-Keramik-Substrat ist dann im Wesentlichen senkrecht auf dem Pad niedergespannt.

Insbesondere wenn zur Strukturierung des Metall-Keramik-Substrats ein Direktbelichtungsverfahren, beispielsweise mit einem Laser vorgesehen ist, ist die Erkennung der genauen Position des Metall-Keramik-Substrats auf dem Pad von Bedeutung. Diese Positionserkennung kann beispielsweise durch ein weiteres Bauelement, wie ein Kamerasystem, gewährleistet werden.

Dieses Bauelement zur Identifizierung der Position des Metall-Keramik-Substrats kann beispielsweise so ausgebildet sein, dass es an mindestens zwei Ecken des Pads die Position des Metall-Keramik-Substrats auf dem Pad erkennt. Das Pad ist daher vorzugsweise so ausgebildet, dass in den Ecken, in denen eine Positionserkennung des Metall-Keramik-Substrats mittels des Bauelements erfolgt, Ausnehmungen vorgesehen sind. Diese Ausnehmungen können eine beliebige Form aufweisen, beispielsweise eckig, oval oder rund sein.

Ein weiterer Gegenstand der vorliegenden Erfindung ist die Verwendung der oben beschriebenen Vorrichtung zum Niederspannen von einem Metall-Keramik-Substrat.

Im Hinblick auf die gegenständlichen Merkmale der erfindungsgemäß zu verwendenden Vorrichtung wird auf obige Ausführungen verwiesen.

Ein weiterer Gegenstand der vorliegenden Erfindung ist ein Verfahren zur Direktbelichtung eines Metall-Keramik-Substrats, gekennzeichnet durch die folgenden Verfahrensschritte:
a. Bereistellen eines unstrukturierten Metall-Keramik-Substrats, das auf mindestens einer Seite des Keramiksubstrats eine durch Belichtung strukturierbare Metallbeschichtung aufweist;
b. Niederspannen des Metall-Keramik-Substrats in einer wie oben beschriebenen Vorrichtung unter Anlegen von Vakuum; und
c. Strukturieren des Metall-Keramik-Substrats durch Direktbelichtung.

Die vorliegende Erfindung wird anhand der nachfolgenden näher erläuterten Figurenbeschreibung näher erläutert.
Figur 1 zeigt eine Aufsicht auf eine erfindungsgemäße Vorrichtung 1.
Figur 2 zeigt eine Seitendarstellung einer erfindungsgemäßen Vorrichtung 1.

Die erfindungsgemäße Vorrichtung 1 umfasst einen Träger 3, der mit einer Mehrzahl an Pads 4 versehen ist. Die Pads 4 dienen als Belichtungsnester für die zu strukturierenden Metall-Keramik-Substrate 2. In dem Pad 4 befinden sie kanalförmige Öffnungen 5, die mit weiteren kanalförmigen Öffnungen 7 in dem Träger 3 kommunizieren können. Über die kanalförmigen Öffnungen 7 des Trägers 3 sowie die kanalförmigen Öffnungen 5 des Pads 4 kann über eine Vakuumeinrichtung 6 ein Vakuum erzeugt werden. Das Pad 4 ist in einer Ausnehmung 8 des Trägers 3 gelagert und weist eine Dichtlippe 9 auf. Das auf dem Pad 4 angeordnete Metall-Keramik-Substrat 2 weist eine Grundfläche 11 auf, die größer ist als die Grundfläche 10 des Pads 4. Lateral neben der Ausnehmung 8 weist die erfindungsgemäße Vorrichtung 1 in dem Träger 3 eine Ausfräsung 12 auf, in welcher sich bei dem Niederspannen des Metall-Keramik-Substrats gegebenenfalls bildende Partikel ansammeln können. Die entsprechenden Partikel können über eine Saugvorrichtung 14 von dem Träger 3 entfernt werden. Darüber hinaus ist ein Bauteil 16 zur Erkennung der Position des Metall-Keramik-Substrats 2 auf dem Pad 4 vorgesehen.

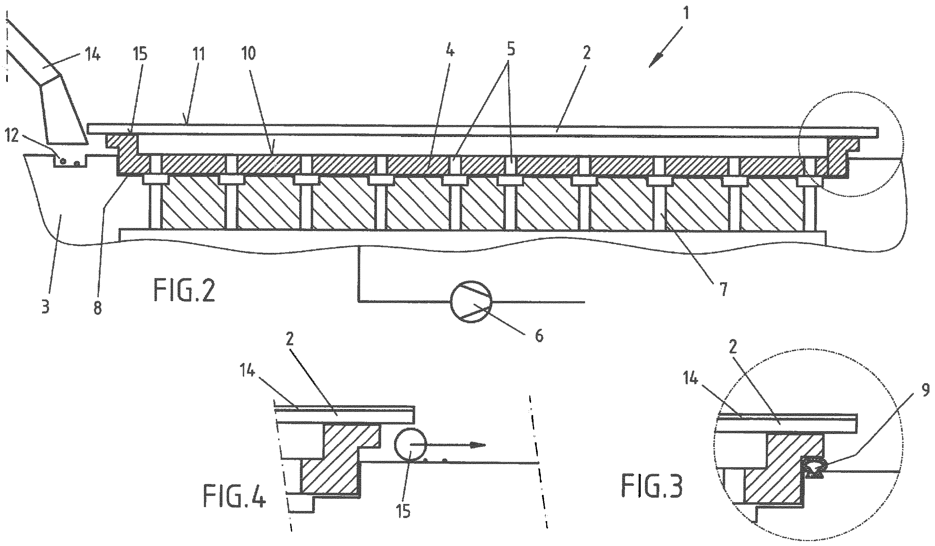

Die Figur 3 zeigt vergrößert einen Ausschnitt der erfindungsgemäßen Vorrichtung 1, in welchem die Dichtlippe 9, die das Pad 4 umgibt und die sich über die Ausnehmung 8 erstreckt, verdeutlicht wird.

Die Figur 4 zeigt vergrößert einen Ausschnitt der erfindungsgemäßen Vorrichtung 1, in welchem Adhesivsrollen 15 vorgesehen sind, mit den Partikel, die bei dem Niederspannen des Metall-Keramik-Substrats sich gegebenenfalls ablösen, aus der Vorrichtung 1 entfernt werden können.

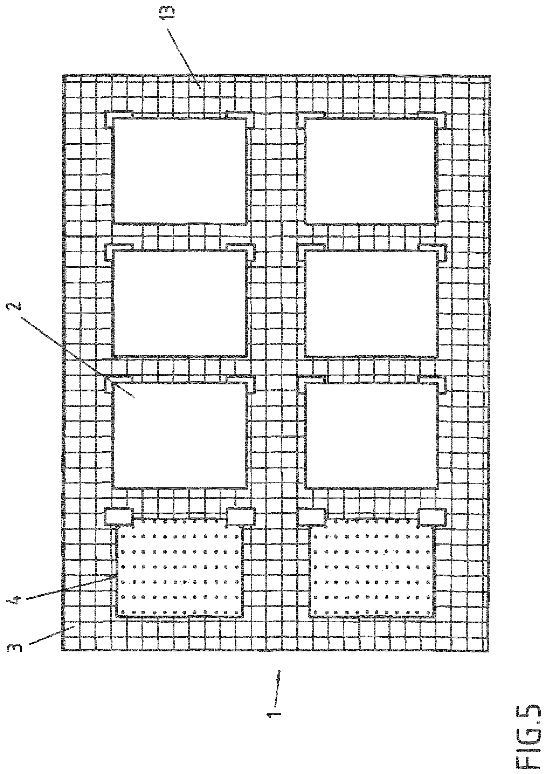

Die Figur 5 zeigt eine alternative Ausführungsform der erfindungsgemäßen Vorrichtung 1, bei welcher der Träger 3 als Gitterstruktur 13 ausgebildet ist, auf welches sich die Pads 4 befinden. Partikel, die durch das Niederspannen des Metall-Keramik-Substrats 2 gebildet werden, können durch die Gitterstruktur 13 in einen darunterliegenden Bereich fallen und stören daher die Strukturierungsvorgänge der Metall-Keramik-Substrate nicht.

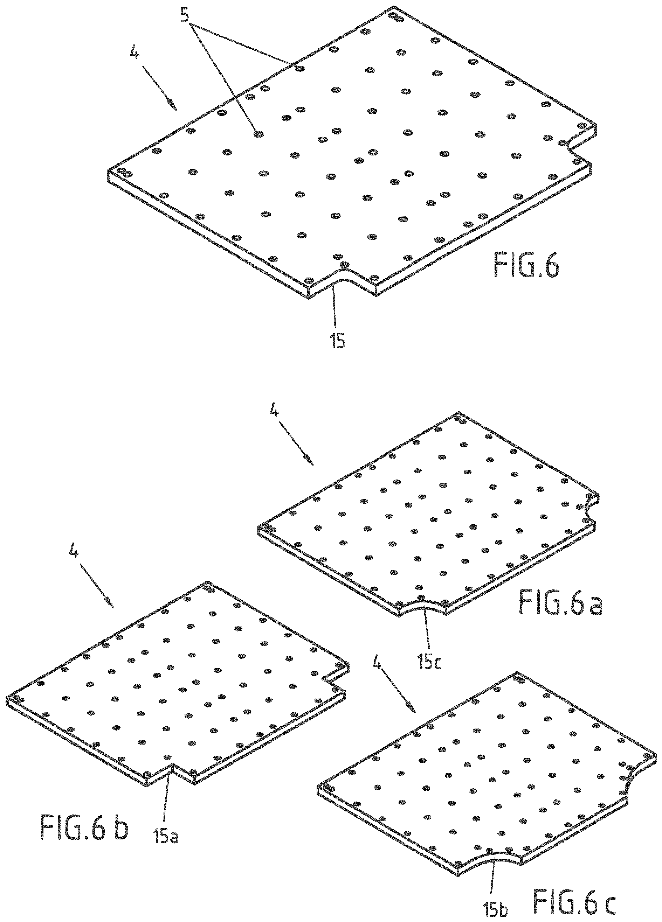

Die Figur 6 zeigt unterschiedliche geometrische Formen des Pads 4, bei welchen in den Ecken verschiedene Aussparrungen 15a, 15b und 15c vorgesehen sind. An den Aussparrungen 15a, 15b und 15c erfolgt mit dem Bauteil die Erkennung der Position des Metall-Keramik-Substrats 2 auf dem Pad 4.

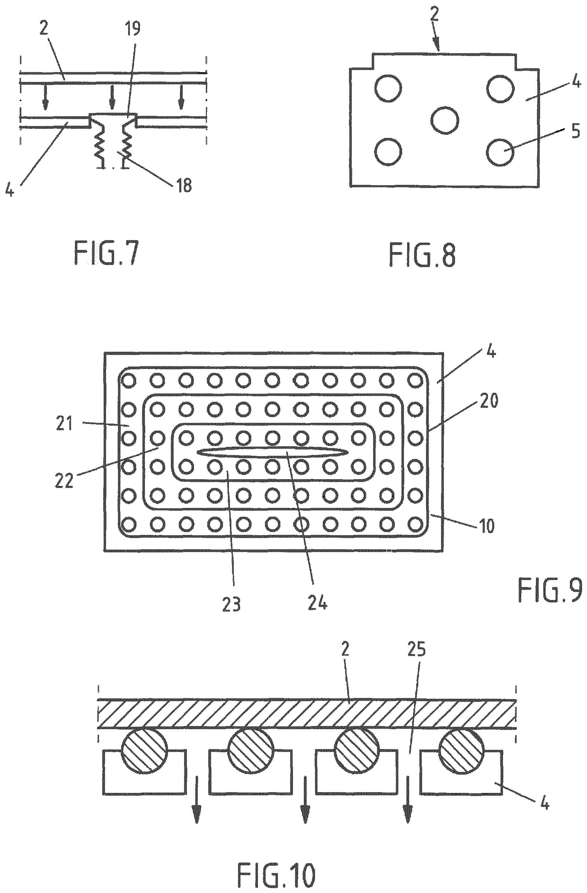

Die Figur 7 zeigt eine alternative Ausgestaltung des Pads 4, bei welcher ein Balgsauger 18 in das Pad 4 eingelassen ist. Mit Hilfe des Saugnapfs 19 kann der Balgsauger 18 effektiv an das zu niederspannende Metall-Keramik-Substrat herangeführt werden. Bei einem anschließenden Evakuieren des Balgsaugers 18 ist insgesamt ein kleineres Volumen durch das Vakuum zu entfernen.

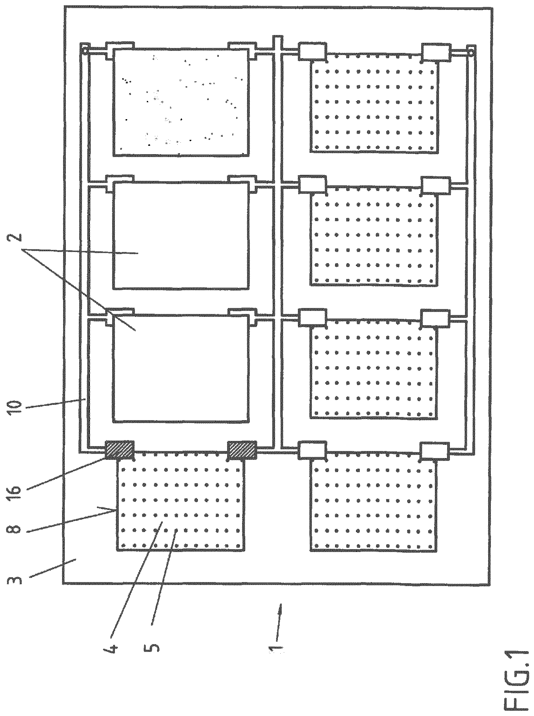

Die Figur 8 zeigt ein Pad 4, in welche mehrere Balgsauger 18 eingelassen werden können. Bei der Verwendung von Balgsaugern 18 sind die Öffnungen 5 im Pad 4 größer als bei der Ausgestaltung gemäß den Figuren 1 und 2. Im Vergleich zur Ausgestaltung gemäß den Figuren 1 und 2 ist eine geringere Anzahl an Öffnungen 5 in dem Pad 4 erforderlich.

Die Figur 9 zeigt eine weitere Ausgestaltung des Pads 4. Auf dem Pad 4 verlaufen schnurähnliche Erhöhungen 20, auf welchen das Metall-Keramik-Substrat 2 platziert wird. Durch die schnurförmigen Erhöhungen 20 wird die Grundfläche 10 des Pads 4 in eine Mehrzahl an voneinander abgetrennten Bereichen 21, 22, 23 und 24 unterteilt, die durch die schnurförmigen Erhöhungen im Wesentlichen luftdicht voneinander abgeschlossen sind. Durch diese Anordnung der schnurförmigen Erhöhungen 20 entstehen Volumenräume, die einfacher zu evakuieren sind.

Die Figur 10 zeigt eine Seitenansicht des erfindungsgemäßen Pads 4 gemäß Figur 9, in welcher durch die schnurförmigen Erhöhungen 20 einzelne Volumenräume 25 zwischen dem Pad 4 und dem Metall-Keramik-Substrat 2 gebildet werden gebildet werden.

### Bezugszeichenliste:

- 1:: Vorrichtung zum Niederspannen von Metall-Keramik-Substraten
- 2:: Metall-Keramik-Substrat
- 3:: Träger
- 4:: Pad
- 5:: Öffnungen im Pad
- 6:: Vakuumeinrichtung
- 7:: Öffnungen im Träger
- 8:: Ausnehmung
- 9:: Dichtlippe
- 10:: Grundfläche des Pads 4
- 11:: Grundfläche des Metall-Keramik-Substrats 2
- 12:: Ausfräsung
- 13:: Gitterstruktur
- 14:: Saugvorrichtung
- 15:: Adhesivrollen
- 16:: Bauteil zur Erkennung der Position des Metall-Keramik-Substrats 2 auf dem Pad 4
- 17:: Ausnehmungen im Pad 4 (15a, 15b, 15c)
- 18:: Balgsauger
- 19:: Saugnapf des Balgsaugers
- 20:: schnurähnliche Erhöhungen auf dem Pad 4
- 21:: Unterbereich des Pads 4
- 22:: Unterbereich des Pads 4
- 23:: Unterbereich des Pads 4
- 24:: Unterbereich des Pads 4
- 25:: Volumenräume

## Patentansprüche

1. Vorrichtung (1) zum Niederspannen von Metall-Keramik-Substraten (2), umfassend
a. ein Metall-Keramik-Substrat (2);
b. einen Träger (3), der ein Pad (4) aufweist, welches gegenüber dem Träger (3) erhöht ist und Öffnungen (5) aufweist.

2. Vorrichtung (1) nach Patentanspruch 1, wobei die Öffnungen (5) mit einer Vorrichtung zur Erzeugung eines Vakuums (6) verbunden sind.

3. Vorrichtung (1) nach Patentanspruch 1 oder 2, wobei der Träger (3) Öffnungen (7) aufweist, wobei die Öffnungen (7) des Trägers (3) und die Öffnungen (5) des Pads (4) so zueinander angeordnet sind, dass sie miteinander kommunizieren können und die Öffnungen (7) des Trägers (3) mit einer Vorrichtung zur Erzeugung eines Vakuums (6) verbunden sind.

4. Vorrichtung (1) nach einem der Patentansprüche 1 bis 3, wobei das Pad (4) schnurförmige Erhöhungen (20) aufweist, auf welchen das Metall-Keramik-Substrat (2) positioniert wird und welche den Raum zwischen Pad (4) und Metall-Keramik-Substrat (2) unterteilen.

5. Vorrichtung (1) nach Patentanspruch 1, wobei das Pad (4) Öffnungen (5) aufweist, in welche Balgsauger (6) eingefasst sind und die Balgsauger (6) mit einer Vorrichtung zur Erzeugung eines Vakuums (6) verbunden sind.

6. Vorrichtung (1) nach einem der Patentansprüche 1 bis 5, wobei das Material der Pads (4) einen elastisch verformbaren Kunststoff umfasst.

7. Vorrichtung (1) nach einem der Patentansprüche 1 bis 6, zusätzlich umfassend ein auf dem Pad (4) angeordnetes niedergespanntes Metall-Keramik-Substrat (2), wobei das niedergespannte Metall-Keramik-Substrat (2) eine größere Grundfläche (11) aufweist als die Grundfläche (10) des Pads (4).

8. Vorrichtung (1) nach Patentanspruch 7, wobei das Pad (4) gegenüber dem Träger (3) derart erhöht ist, dass ein auf dem Pad (4) niedergespanntes Metall-Keramik-Substrat (2), dessen Oberfläche (11) sich über die Oberfläche (10) des Pads (4) erstreckt, von dem Träger (3) beabstandet ist.

9. Vorrichtung (1) nach einem der Patentansprüche 1 bis 8, wobei der Träger (3) ein Bauelement (14) umfasst, welches die Position des Metall-Keramik-Substrats (2) auf dem Pad (4) erkennt.

10. Vorrichtung (1) nach Patentanspruch 9, wobei das Bauelement (14) so ausgebildet ist, dass es an mindestens zwei Ecken des Pads (4) die Position der Metall-Keramik-Substrats (2) auf dem Pad (4) erkennt.

11. Verwendung der Vorrichtung (1) gemäß einem der Patentansprüche 1 bis 10 zum Niederspannen von einem Metall-Keramik-Substrat (2).

12. Verwendung nach Patentanspruch 11 in einem Verfahren der Direktbelichtung von Metall-Keramik-Substraten (2).

13. Verwendung nach Patentanspruch 11 oder 12, wobei das niedergespannte Metall-Keramik-Substrat (2) eine größere Grundfläche (11) aufweist als das Pad (4).

14. Verfahren zur Direktbelichtung eines Metall-Keramik-Substrats (2), wobei das Verfahren die folgenden Verfährensschritte aufweist:
a. Bereitstellen eines unstrukturierten Metall-Keramik-Substrats (2), das auf mindestens einer Seite des Keramiksubstrats eine durch Belichtung strukturierbare Metallbeschichtung aufweist;
b. Niederspannen des Metall-Keramik-Substrats (2) in einer Vorrichtung gemäß einem der Patentansprüche 1 bis 10 unter Anlegung von Vakuum;
c. Strukturieren des Metall-Keramik-Substrats (2) durch Direktbelichtung.

15. Verfahren nach Patentansprüche 14, wobei das niedergespannte Metall-Keramik-Substrat (2) eine größere Grundfläche (11) aufweist als das Pad (4).

## Claims

1. A device (1) for down-stretching metal ceramic substrates (2), comprising
a. a metal ceramic substrate (2);
b. a support (3), which comprises a pad (4), which is elevated with respect to the support (3) and comprises openings (5).

2. A device (1) according to claim 1, wherein the openings (5) are connected to a device for generating a vacuum (6).

3. A device (1) according to claim 1 or 2, wherein the support (3) comprises openings (7), wherein the openings (7) of the support (3) and the openings (5) of the pad (4) are arranged with respect to each other, such that they communicate with each other, and the openings (7) of the support (3) are connected to a device for generating a vacuum (6).

4. A device (1) according to one of the claims 1 through 3, wherein the pad (4) comprises string-like elevations (20), on which the metal ceramic substrate (2) is positioned, and which divide the space between the pad (4) and the metal ceramic substrate (2).

5. A device (1) according to claim 1, wherein the pad (4) comprises openings (5), in which bellows suction pads (6) are inserted, and the bellows suction pads (6) are connected to a device for generating a vacuum (6).

6. A device (1) according to one of the claims 1 through 5, wherein the material of the pads (4) comprises an elastically deformable plastic.

7. A device (1) according to one of the claims 1 through 6, additionally comprising a down-stretched metal ceramic substrate (2) that is arranged on the pad (4), wherein the down-stretched metal ceramic substrate (2) comprises a larger base area (11) than the base area (10) of the pad (4).

8. A device (1) according to claim 7, wherein the pad (4) is elevated with respect to the support (3), such that a metal ceramic substrate (2), which is down-stretched on the pad (4) and the surface (11) of which extends over the surface (10) of the pad (4), is spaced apart from the support (3).

9. A device (1) according to one of the claims 1 through 8, wherein the support (3) includes a component (14), which detects the position of the metal ceramic substrate (2) on the pad (4).

10. A device (1) according to claim 9, wherein the component (14) is configured, such that it detects the position of the metal ceramic substrate (2) on the pad (4) at not less than two corners of the pad (4).

11. A use of the device (1) according to one of the claims 1 through 10 for down-stretching a metal ceramic substrate (2).

12. A use according to claim 11 in a method of direct exposure of metal ceramic substrates (2).

13. A use according to claim 11 or 12, wherein the down-stretched metal ceramic substrate (2) comprises a larger base area (11) than the one of the pad (4).

14. A method for the direct exposure of a metal ceramic substrate (2), wherein the method comprises the following process steps:
a. providing an unstructured metal ceramic substrate (2), which comprises a metal coating that can be structured by means of exposure on at least one side of the ceramic substrate;
b. down-stretching the metal ceramic substrate (2) in a device according to one of the claims 1 through 10 while applying a vacuum;
c. structuring the metal ceramic substrate (2) by means of direct exposure.

15. A method according to claim 14, wherein the down-stretched metal ceramic substrate (2) comprises a larger base area (11) than the one of the pad (4).

## Revendications

1. Dispositif (1) de serrage en bas des substrats métal-céramique (2), comprenant
a. un substrat métal-céramique (2) ;
b. un support (3), qui comprend un coussinet (4), qui est élevé par rapport au support (3), et qui comprend des ouvertures (5).

2. Dispositif (1) selon la revendication 1, dans lequel les ouvertures (5) sont reliées à un dispositif pour générer un vide (6).

3. Dispositif (1) selon la revendication 1 ou la revendication 2, dans lequel le support (3) comprend des ouvertures (7), les ouvertures (7) du support (3) et les ouvertures (5) du coussinet (4) étant disposées les unes par rapport aux autres, de sorte qu'elles peuvent communiquer les unes avec les autres et que les ouvertures (7) du support (3) sont reliées à un dispositif pour générer un vide (6).

4. Dispositif (1) selon l'une des revendications 1 à 3, dans lequel le coussinet (4) comprend des élévations (20) en forme de cordon, sur lesquelles le substrat métal-céramique (2) est positionné, et lesquelles divisent l'espace entre le coussinet (4) et le substrat métal-céramique (2).

5. Dispositif (1) selon la revendication 1, dans lequel le coussinet (4) comprend des ouvertures (5), dans lesquelles sont insérés des soufflets à ventouse (6), et les soufflets à ventouse (6) sont reliés à un dispositif pour générer un vide (6).

6. Dispositif (1) selon l'une des revendications 1 à 5, dans lequel le matériau du coussinet (4) comprend une matière plastique élastiquement déformable.

7. Dispositif (1) selon l'une des revendications 1 à 6, comprenant supplémentairement un substrat métal-céramique serré en bas et disposé sur le coussinet (4), dans lequel le substrat métal-céramique serré en bas (2) comprend une surface de base (11) plus grande que la surface de base (10) du coussinet (4).

8. Dispositif (1) selon la revendication 7, dans lequel le coussinet (4) est élevé par rapport au support (3), de sorte qu'un substrat métal-céramique, qui est serré en bas sur le coussinet (4), et dont la surface (11) s'étend sur la surface (10) du coussinet (4), est espacé du support (3).

9. Dispositif (1) selon l'une des revendications 1 à 8, dans lequel le support (3) comprend un composant (14), qui détecte la position du substrat métal-céramique (2) sur le coussinet (4).

10. Dispositif (1) selon la revendication 9, dans lequel le composant (14) est configuré, de sorte qu'il détecte la position du substrat métal-céramique (2) sur le coussinet (4) à au moins deux coins du coussinet (4).

11. Utilisation du dispositif (1) selon l'une des revendications 1 à 10 pour serrer un substrat métal-céramique (2) en bas.

12. Utilisation selon la revendication 11 dans un procédé d'exposition directe des substrats métal-céramique (2).

13. Utilisation selon la revendication 11 ou la revendication 12, dans laquelle le substrat métal-céramique (2) serré en bas comprend une plus grande surface de base que celle du coussinet (4).

14. Procédé d'exposition directe d'un substrat métal-céramique (2), dans lequel le procédé comprend les étapes de procédé suivantes de :
a. fournir un substrat métal-céramique (2) non structuré, qui comprend un revêtement métallique susceptible d'être structuré par une exposition sur au moins une face du substrat céramique ;
b. serrer le substrat métal-céramique (2) en bas dans un dispositif selon l'une des revendications 1 à 10 en appliquant un vide ;
c. structurer le substrat métal-céramique (2) par moyen d'exposition directe.

15. Procédé selon la revendication 14, dans lequel le substrat métal-céramique (2) serré en bas comprend une plus grande surface de base (11) que celle du coussinet (4).
